# FASCICULE DE BREVET EUROPEEN

(11) **EP 2 663 495 B1**
(45) Date de publication et mention de la délivrance du brevet: **04.03.2015**
(21) Numéro de dépôt: 12702606.0
(22) Date de dépôt: 10.01.2012
(51) Int. Cl.: B64D 43/00, H05K 5/00, H05K 5/02, H05K 13/00

(54) **PANNEAU SUPERIEUR POUR COCKPIT D'AERONEF ET AERONEF COMPRENANT UN TEL PANNEAU**
OBERE PLATTE FÜR EIN FLUGZEUGCOCKPIT UND FLUGZEUG MIT EINER SOLCHEN PLATTE
OVERHEAD PANEL FOR AN AIRCRAFT COCKPIT AND AIRCRAFT INCLUDING SUCH A PANEL

(30) Priorité: 12.01.2011 FR 1150248
(43) Date de publication de la demande: 20.11.2013
(73) Titulaire: Airbus Operations, 31060 Toulouse (FR)
(72) Inventeur: GUERING, Bernard, F-31850 Montrabe (FR)
(74) Mandataire: Ahner, Philippe
(86) Numéro de dépôt international: PCT/FR2012/050064
(87) Numéro de publication internationale: WO 2012/095605

(56) Documents cités:
- WO-A1-2006/101417
- FR-A1- 2 900 634
- US-A- 5 544 842

## Description

### DOMAINE TECHNIQUE

L'invention concerne un panneau supérieur pour cockpit d'aéronef et un aéronef comprenant un tel panneau. FR 2 900 634 A1 divulgue un tel panneau comprenant les caractéristiques de la préambule de la revendication 1.

Dans la suite, pour des raisons de simplification de la description, on considère un aéronef de type avion.

### ÉTAT DE LA TECHNIQUE ANTÉRIEURE

L'invention intervient dans un contexte de recherche d'amélioration globale des pointes avant d'avions. Dans ce cadre, tous les composants majeurs des cockpits, tels que décrits par exemple dans le document intitulé [1] « Cockpit - ATA100 Chapter 25-10-20 » (« Airbus A340/A330 System description note », 15/9/1993), sont concernés, notamment le panneau supérieur (« overhead panel ») situé au-dessus des pilotes, dont le rôle est de donner un état instantané simplifié des principaux systèmes de l'avion.

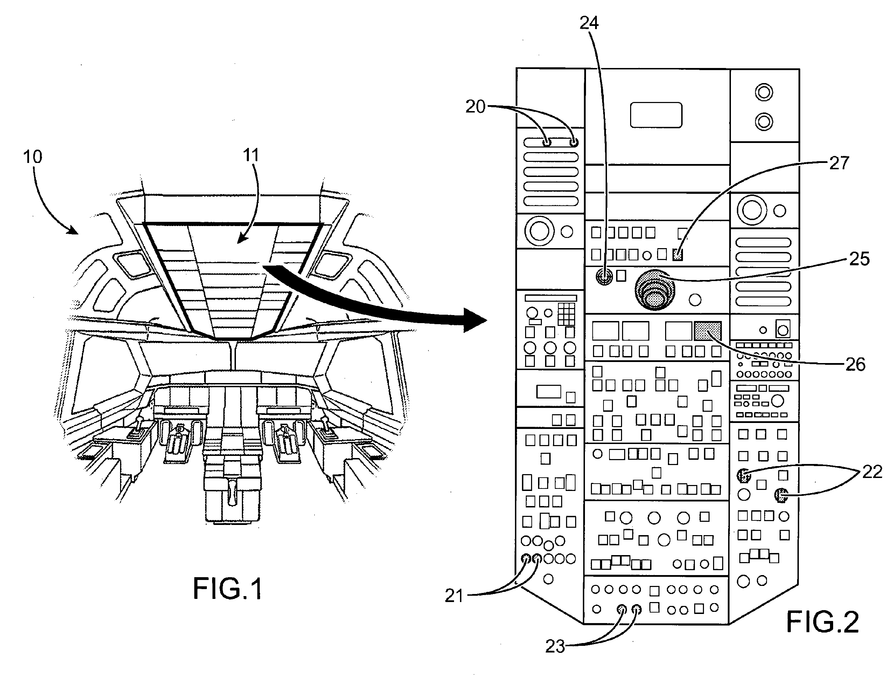

Un tel panneau supérieur 11, qui est illustré sur les figures 1 et 2 respectivement dans un cockpit 10 d'avion et en vue de face, est constitué de sous-modules indépendants. Chaque sous-module est associé à un système particulier ou à une fonction particulière. Ce peut-être par exemple :
- un disjoncteur 20,
- un bouton à impulsion 21,
- un rotateur multi-position 22,
- un inverseur 23,
- un « beeper » (avertisseur sonore) 24,
- une liseuse 25,
- une poignée coupe-feu 26,
- un voyant poussoir multi-étage 27.

Il couvre une surface d'environ 100 mm x 600 mm.

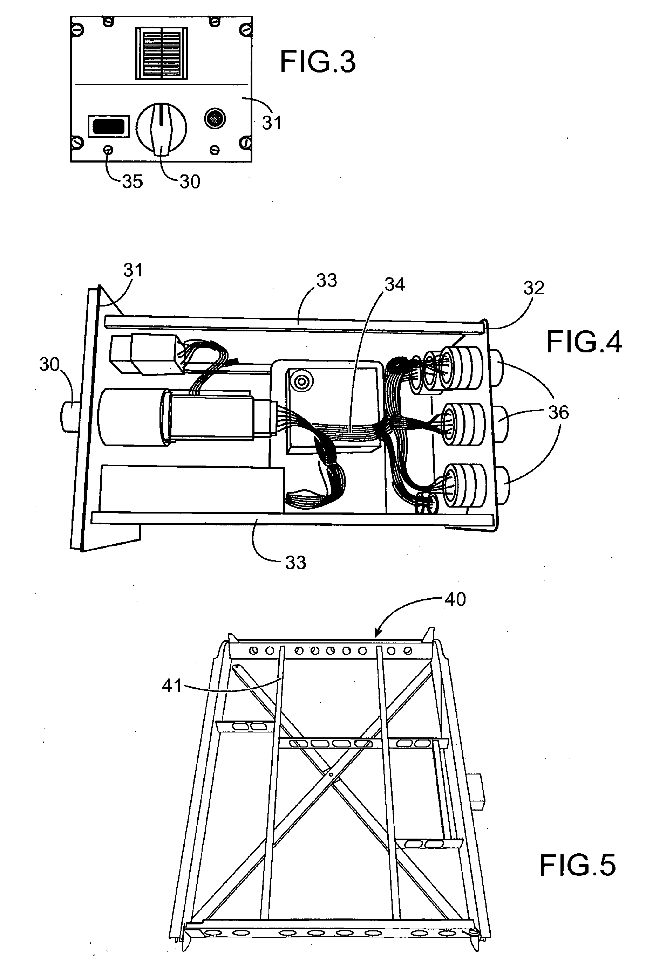

Comme illustré sur les figures 3 et 4, chaque sous-module, ici un rotateur multi-position 30, comprend une platine avant 31 et une platine arrière 32 reliées entre elles par des colonnettes 33. Sur la platine avant 31 sont représentées des fixations rapides 34 dudit sous-module et des fixations 35 d'une étiquette éclairée, par exemple une plaque en plexiglass gravée et éclairée dans son épaisseur ou une plaque luminescente. Chaque sous-module 30 est relié à un ou plusieurs des connecteurs arrières 36, fixés sur la platine arrière 32, par un harnais de connexion 34. Le câblage d'un tel harnais 34 est réalisé, la platine arrière étant pivotée de 180°.

L'ensemble des sous-modules est rapporté sur un châssis support 40 muni de réglettes de fixation 41, comme illustré sur la figure 5. Ce châssis support est lui-même lié rigidement à une structure primaire (ou « drip shield ») épousant la forme du fuselage, qui forme une coque de protection disposée au plus près de la structure de l'avion pour résoudre les problèmes techniques posés par les impacts d'oiseaux sur la carlingue, par les vibrations, par le ruissellement (condensation sur la structure plafond), et par l'usure des contacts (« fretting »).

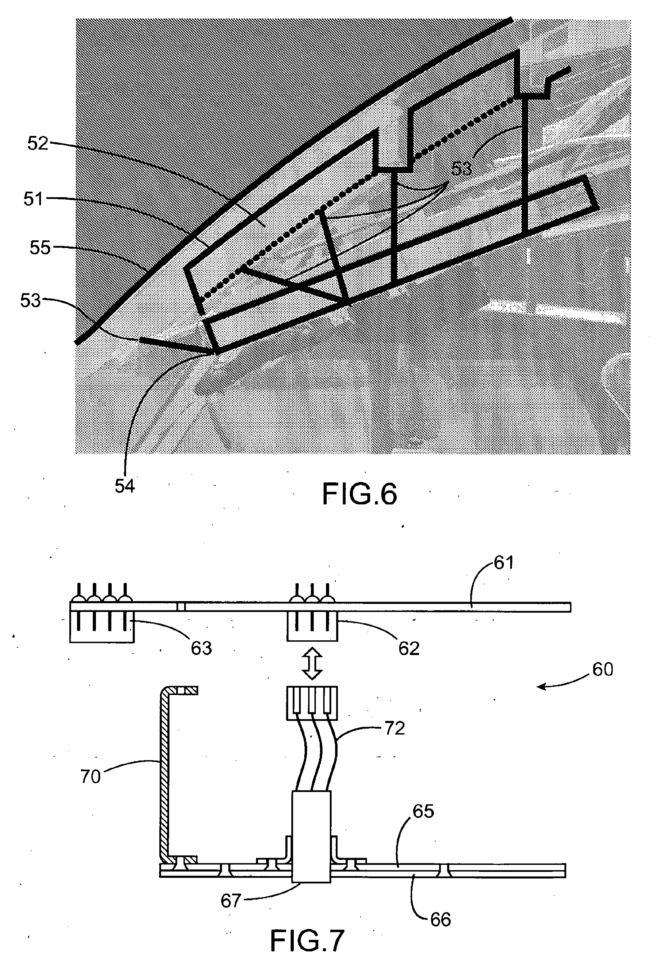

La figure 6 illustre, dans la structure de l'avion, cette coque de protection ou « drip shield » 51, le volume 52 dédié au stockage des câbles, la face des bielles d'attache structurales 53 permettant une liaison rigide entre cette coque de protection 51 et le châssis support 54 du panneau supérieur. La référence 55 illustre la zone sensible à des chocs d'oiseaux.

Le panneau supérieur de l'art antérieur présente de nombreux inconvénients :
- complexité de réalisation (trop de modules et trop de pièces nécessaires à son montage) et donc coût élevé,
- encombrement imposant (nécessité d'un « drip shield » pour la fixation à la structure de l'avion) et poids important,
- installation délicate (accessibilité des câblages), et inspection difficile,
- contrainte aérodynamique (point de passage obligé dans la réalisation d'une forme de pointe avant d'avion),
- ségrégation électrique (1/2),
- sur-longueur importante de câblage (problématique de stockage en zone arrière) et stockage des câbles en aveugle.

L'invention a pour objet de pallier de façon radicale tous ces inconvénients en intégrant en un seul module un ensemble qui était jusqu'à présent constitué d'une multitude d'éléments disposés sur un châssis indépendant.

### EXPOSÉ DE L'INVENTION

L'invention concerne un panneau supérieur apte à être disposé dans un cockpit d'aéronef, caractérisé en ce qu'il comprend un ensemble de sous-modules indépendants associés chacun à un système particulier ou à une fonction particulière de l'avion, intégrés dans un module autoporteur rigide, par exemple de forme parallélépipédique d'épaisseur inférieur à 100 mm, comportant une face avant sur laquelle sont rapportés les sous-modules, et deux faces latérales munies de connecteurs destinés à être reliés à différents systèmes de l'avion.

Avantageusement le module autoporteur comprend :
- une platine arrière comprenant une plaque de circuit intégré sur laquelle sont soudés des connecteurs électriques centraux et des connecteurs périphériques,
- une platine avant, sur laquelle sont rapportés les sous-modules,
- un cadre périmétrique réalisant la jonction entre ces deux platines arrière et avant, sur toute la périphérie du module ;
- des micro-harnais standard, chacun permettant de réaliser la liaison entre un sous-module et un connecteur central disposé sur la platine arrière.

Avantageusement une étiquette lumineuse est disposée sur la platine avant.

Avantageusement la platine avant comprend une tôle dans laquelle sont réalisées des trous d'allègement et d'accessibilité.

Avantageusement le panneau supérieur comprend des plots amortisseurs disposés sur la surface arrière de la platine arrière, par exemple en chacun des coins de cette surface arrière.

Avantageusement la platine arrière peut comprendre une plaque de circuit intégré dont la dernière couche est une couche anti-condensation, ou un petit panneau en matériau thermoplastique.

L'invention concerne également un procédé de fabrication du panneau supérieur qui comprend les étapes suivantes :
- intégration des mini-harnais sur les sous-modules,
- clipsage de ces mini-harnais sur les connecteurs centraux correspondants déjà soudés sur la plaque de circuit intégré,
- fixation de l'ensemble ainsi formé sur le cadre périmétrique,
- accostage de la platine avant en veillant à centrer chacun des sous-modules dans un logement correspondant de la platine avant,
- fixation des sous-modules, sur la platine avant par la face arrière.

Le panneau supérieur de l'invention présente les avantages suivants :
- Réalisation en un module auto-porteur rigide (6 faces travaillantes) comprenant une platine arrière constituée d'un circuit intégré, une platine avant, ces deux platines étant reliées entre elles par un cadre périmétrique, une étiquette lumineuse fixée sur la platine avant, tous les sous-modules étant fixés sur la platine avant tous les composants de connexion étant soudés (une opération) sur la platine arrière, et des mini-harnais d'interface, standardisés et préfabriqués, reliant les sous-modules et les composants de connexion,
- suppression du châssis de l'art antérieur,
- suppression du « drip shield »,
- câblage sécurisé, avec un accès direct, et pas de sur-longueurs,
- montage souple avec quatre amortisseurs (protection contre les chocs et vibrations),
- connecteurs de coupure haute densité disposés latéralement (accès direct aux fixations, ségrégation du système),
- protection ruissellement intégrée,
- réduction du volume global (suppression du châssis/épaisseur constante inférieure à 100 mm).

### BRÈVE DESCRIPTION DES DESSINS

Les figures 1 et 2 illustrent un panneau supérieur de l'art antérieur respectivement disposé dans le cockpit d'un avion et en vue de face avant,
- les figures 3 et 4 illustrent un sous-module du panneau supérieur de l'art antérieur,
- la figure 5 illustre le support châssis du panneau supérieur de l'art antérieur,
- la figure 6 illustre la fixation du panneau supérieur de l'art antérieur à la structure de l'avion,
- la figure 7 illustre une vue partielle schématique du panneau supérieur de l'invention,
- les figures 8 et 9 illustrent le panneau supérieur de l'invention respectivement dans une vue de dessus et de dessous,
- la figure 10 illustre la fixation du panneau supérieur de l'invention à la structure d'un avion,
- les figures 11A à 11G illustrent les différentes étapes d'assemblage du panneau supérieur de l'invention.

### EXPOSÉ DÉTAILLÉ DE MODES DE RÉALISATION PARTICULIERS

Comme illustré sur la figure 7, le panneau supérieur de l'invention 60 comprend un module auto-porteur rigide formé de :
- une platine arrière 61 comprenant une plaque de circuit intégré sur laquelle sont soudés des connecteurs électriques centraux 62 destinés à être reliés aux sous-modules 67, et des connecteurs électriques périphériques 63 destinés à être reliés aux différents systèmes de l'avion,
- une platine avant 65, qui est formée d'une tôle sur laquelle sont rapportés les sous-modules 67 (ici un bouton poussoir) décrits précédemment dans le dispositif de l'art connu, une étiquette lumineuse, pouvant être éclairée, étant disposée sur la face avant de cette platine avant,
- un cadre périmétrique 70 réalisant la jonction entre ces deux platines arrière et avant, sur toute la périphérie du module,
- des micro-harnais standard 72, chacun permettant de réaliser la liaison entre un sous-module 67 et un connecteur central correspondant 62 disposé sur la platine arrière, cette connexion étant facile et rapide à réaliser.

Cet ensemble forme un module auto-porteur rigide, avec 6 faces travaillantes.

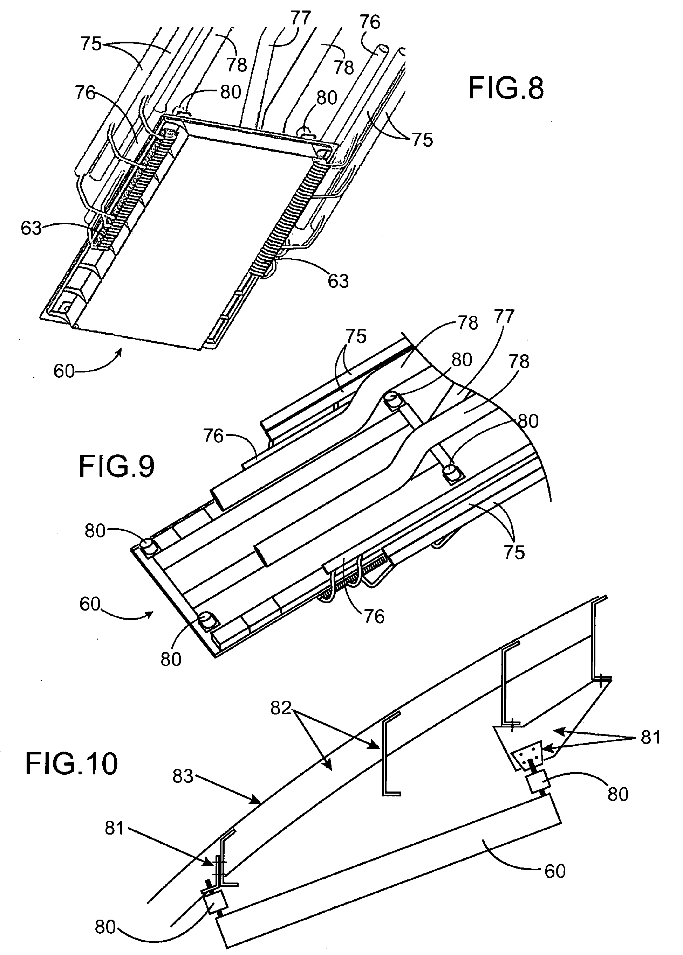

Comme illustré sur les figures 8 et 9, le panneau supérieur de l'invention est, par l'intermédiaire de ses connecteurs électriques périphériques 63, relié à :
- des liaisons 75 intitulées « Route M » (M comme « moyenne »), qui sont des câbles de faible puissance ne nécessitant pas de protection importante (fonctions classiques),
- des liaisons 76 intitulées « Route S » (S comme « sensible ») qui sont des câbles coaxiaux, qui sont ségrégés à part.

Sur ces figures sont également représentées une conduite 77 d'extraction de calories produites par le panneau supérieur, et deux conduites 78 de climatisation se terminant chacune par une bouche de diffusion pour amener de l'air frais au cockpit, qui ne sont pas reliées au panneau supérieur de l'invention mais passent à proximité de celui-ci.

Comme illustré sur ces figures, quatre plots amortisseurs 80 sont disposés aux quatre coins de la surface arrière de la platine arrière du panneau supérieur de l'invention.

La tôle formant la platine avant peut être percée de trous d'allègement et d'accessibilité. La face avant de la platine avant, qui correspond aux différents systèmes et fonctions de l'avion représentés, est figée pour un programme avion de façon à être facilement compréhensible par les pilotes.

Avantageusement, la platine arrière comprend un circuit intégré qui résiste à la condensation. A cet effet, il peut comprendre une dernière couche spécifique, ou être disposé sur un petit panneau en matériau thermoplastique.

Comme illustré sur la figure 10, le panneau supérieur de l'invention 60 est disposé sur des petits supports intermédiaires 81 fixés sur la structure de l'avion 82 (la référence 83 représente le profil aérodynamique de l'avion), quatre plots amortisseurs 80 étant disposés entre la surface arrière de la platine arrière et ces petits supports intermédiaires 81.

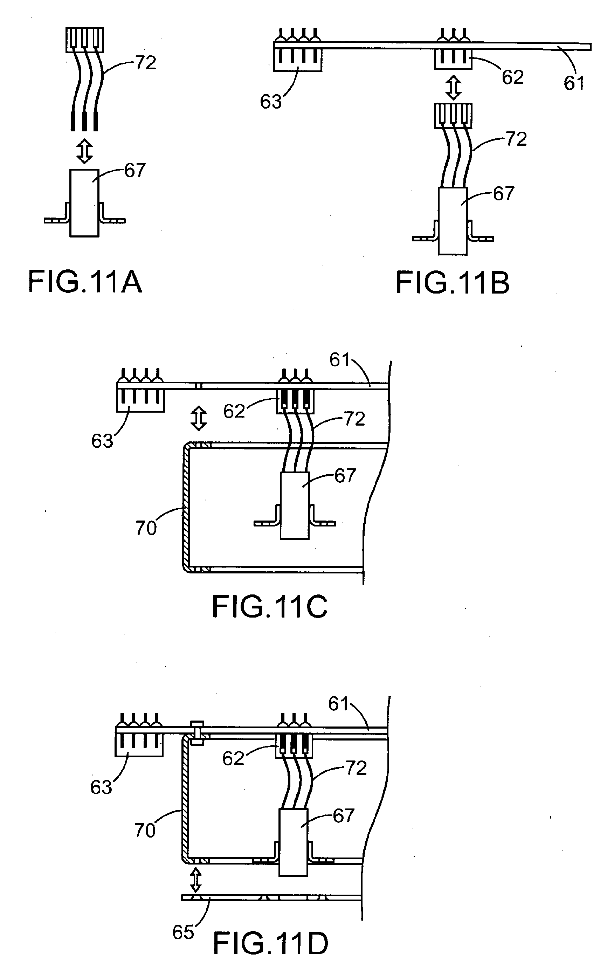

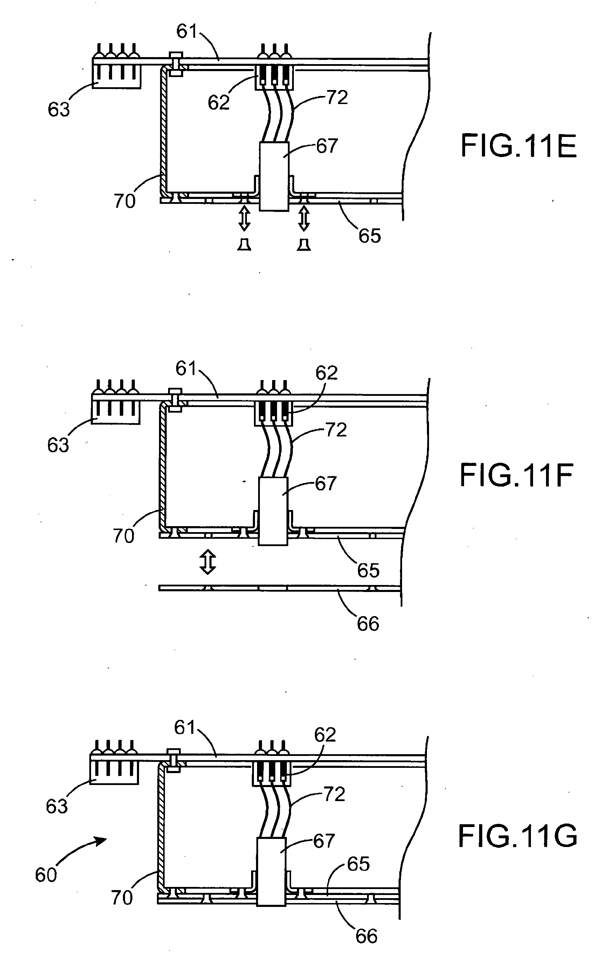

L'assemblage du panneau supérieur de l'invention comprend les étapes suivantes illustrées sur les figures 11A à 11G :
1. intégration des mini-harnais 72 sur les sous-modules 67, par exemple des boutons d'action ou des voyants (figure 11A),
2. clipsage de ces mini-harnais 72 sur les connecteurs centraux correspondants 62 déjà soudés sur la plaque de circuit intégré de la platine arrière 61 (figure 11B),
3. fixation de l'ensemble ainsi formé sur le cadre périmétrique 70 (figure 11C),
4. accostage de la platine avant 65 en veillant à centrer chacun des sous-modules 67 dans un logement correspondant de la platine avant. Avantageusement, le cadre périmétrique ainsi que la platine avant sont ajourés localement ce qui permet de recentrer les objets dans leurs logements plus facilement à l'aide d'outils si nécessaire (figure 11D),
5. fixation des sous-modules 67, par exemple des boutons d'action, sur la platine avant 65 (figure 11E),
6. montage et fixation de l'étiquette éclairée 66 (figure 11F).

La figure 11G illustre l'ensemble du panneau supérieur 60 prêt à être installé dans le cockpit d'un avion.

## Revendications

1. Panneau supérieur apte à être disposé dans un cockpit d'aéronef, qui comprend un ensemble de sous-modules indépendants (67) associés chacun à un système particulier ou à une fonction particulière de l'avion, **caractérisé en ce que** les sous-modules sont intégrés dans un module autoporteur rigide (60), comportant une face avant (65) sur laquelle sont rapportés les sous-modules (67), et deux faces latérales munies de connecteurs électriques périphériques (63) destinés à être reliés à différents systèmes de l'avion.

2. Panneau supérieur selon la revendication 1, dans lequel le module autoporteur rigide (60) est de forme parallélépipédique d'épaisseur inférieur à 100 mm.

3. Panneau supérieur selon la revendication 1, dans lequel le module (60) comprend :
- une platine arrière (61) comprenant une plaque de circuit intégré sur laquelle sont soudés des connecteurs électriques centraux (62) et les connecteurs électriques périphériques (63),
- une platine avant (65) sur laquelle sont rapportés les sous-modules (67),
- un cadre périmétrique (70) réalisant la jonction entre ces deux platines arrière et avant, sur toute la périphérie du module ;
- des micro-harnais (72), réalisant chacun la liaison entre un sous-module (67) et un connecteur central (62) disposé sur la platine arrière.

4. Panneau selon la revendication 3, dans lequel une étiquette lumineuse (66) est disposée sur la platine avant.

5. Panneau supérieur selon la revendication 1, dans lequel la platine avant (65) comprend une tôle dans laquelle sont réalisées des trous d'allègement et d'accessibilité.

6. Panneau supérieur selon la revendication 3 comprenant des plots amortisseurs (80) disposés sur la surface arrière de la platine arrière (61).

7. Panneau supérieur selon la revendication 3, dans lequel la platine arrière (61) comprend une plaque de circuit intégré dont la dernière couche est une couche spécifique anti-condensation.

8. Panneau supérieur selon la revendication 3, dans lequel la platine arrière (61) comprend un petit panneau en matériau thermoplastique anti-condensation.

9. Procédé de fabrication du panneau supérieur selon la revendication 3, qui comprend les étapes suivantes :
- intégration de mini-harnais (72) sur les sous-modules (67),
- clipsage de ces mini-harnais (72) sur les connecteurs centraux (62) correspondants déjà soudés sur la plaque de circuit intégré de la platine arrière (61),
- fixation de l'ensemble ainsi formé sur le cadre périmétrique (70),
- accostage de la platine avant (65) en veillant à centrer chacun des sous-modules (67) dans un logement correspondant de la platine avant (65),
- fixation des sous-modules (67), sur la platine avant (65).

10. Aéronef comprenant un cockpit dans lequel est installé un panneau supérieur selon l'une quelconque des revendications 1 à 8.

## Patentansprüche

1. Deckenkonsole, die in einem Flugzeug-Cockpit angeordnet sein kann und die eine Anordnung unabhängiger Untermodule (67) umfasst, die jeweils einem bestimmten System oder einer bestimmten Funktion des Flugzeugs zugeordnet sind, **dadurch gekennzeichnet, dass** die Untermodule in ein starres, selbsttragendes Modul (60) integriert sind, das eine vordere Fläche (65), auf der die Untermodule (67) angebracht sind, und zwei seitliche Flächen, die mit peripheren elektrischen Verbindern (63) versehen sind, die dazu bestimmt sind, mit verschiedenen Systemen des Flugzeugs verbunden zu werden, aufweist.

2. Deckenkonsole nach Anspruch 1, wobei das starre, selbsttragende Modul (60) spatförmig ist und eine Dicke von weniger als 100 mm besitzt.

3. Deckenkonsole nach Anspruch 1, wobei das Modul (60) Folgendes umfasst:
- eine hintere Platine (61), die eine integrierte Schaltungsplatte aufweist, auf der zentrale elektrische Verbinder (62) und die peripheren elektrischen Verbinder (63) angelötet sind,
- eine vordere Platine (65), auf der die Untermodule (67) angebracht sind,
- einen Umfangsrahmen (70), der die Verbindung zwischen diesen zwei Platinen, der hinteren und der vorderen Platine, auf dem gesamten Umfang des Moduls verwirklicht;
- Mikrokabelstränge (72), die jeweils die Verbindung zwischen einem Untermodul (67) und einem auf der hinteren Platine angeordneten zentralen Verbinder (62) verwirklichen.

4. Konsole nach Anspruch 3, wobei auf der vorderen Platine eine Leuchtmarkierung (66) angeordnet ist.

5. Deckenkonsole nach Anspruch 1, wobei die vordere Platine (65) ein Blech aufweist, in dem Entlastungs- und Zugangslöcher verwirklicht sind.

6. Deckenkonsole nach Anspruch 3, die Dämpfungskissen (80) aufweist, die auf der hinteren Fläche der hinteren Platine (61) angeordnet sind.

7. Deckenkonsole nach Anspruch 3, wobei die hintere Platine (61) eine integrierte Schaltungsplatte aufweist, deren letzte Schicht eine spezifische Kondensationsverhinderungsschicht ist.

8. Deckenkonsole noch Anspruch 3, wobei die hintere Platine (61) eine kleine Platte aus thermoplastischem Kondensationsverhinderungsmaterial aufweist.

9. Verfahren zum Herstellen einer Deckenkonsole nach Anspruch 3, das die folgenden Schritte umfasst:
- Integrieren von Minikabelsträngen (72) in die Untermodule (67),
- Einrasten dieser Minikabelstränge (72) an den entsprechenden zentralen Verbindern (62), die bereits auf die integrierte Schaltungsplatte der hinteren Platine (61) gelötet worden sind,
- Befestigen der so gebildeten Gesamtheit an dem Umfangsrahmen (70),
- Ankoppeln der vorderen Platine (65) unter Beachtung einer Zentrierung jedes der Untermodule (67) in einem entsprechenden Aufnahmesitz der vorderen Platine (65),
- Befestigen der Untermodule (67) an der vorderen Platine (65).

10. Flugzeug, das ein Cockpit aufweist, in dem eine Deckenkonsole nach einem der Ansprüche 1 bis 8 installiert ist.

## Claims

1. An overhead panel able to be positioned in an aircraft cockpit, which includes an assembly of independent submodules (67), each of which is associated with a particular system or a particular function of the aeroplane, **characterised in that** the submodules are incorporated in a rigid self-supporting module (60), including a front face (65) to which the submodules (67) are attached, and two side faces fitted with peripheral electrical connectors (63) intended to be connected to different systems of the aeroplane.

2. An overhead panel according to claim 1, in which the rigid self-supporting module (60) is parallelepipedic in shape and less than 100 mm thick.

3. An overhead panel according to claim 1, in which the module (60) includes:
- a rear plate (61) including an integrated circuit plate to which central electrical connectors (62) and the peripheral electrical connectors (63) are welded,
- a front plate (65), to which the submodules (67) are attached,
- a perimeter frame (70) forming the junction between these two rear and front plates, over entire periphery of the module;
- micro-harnesses (72), each making a connection between a submodule (67) and a central connector (62) positioned on the rear plate.

4. A panel according to claim 3, in which an illuminated label (66) is positioned on the front plate.

5. An overhead panel according to claim 1, in which the front plate (65) includes a metal sheet in which weight reduction and accessibility holes are made.

6. An overhead panel according to claim 3 including dampening pins (80) positioned on the rear surface of the rear plate (61).

7. An overhead panel according to claim 3, in which the rear plate (61) includes an integrated circuit plate the final layer of which is a specific anti-condensation layer.

8. An overhead panel according to claim 3, in which the rear plate (61) includes a small panel made of thermoplastic anti-condensation material.

9. A method for manufacturing the overhead panel according to claim 3, which includes the following steps:
- integration of mini-harnesses (72) on the submodules (67),
- clipping of these mini-harnesses (72) on the corresponding central connectors (62) previously welded on the integrated circuit plate of rear plate (61),
- attachment of the assembly formed in this manner to the perimeter frame (70),
- docking of the front plate (65), ensuring that each of submodules (67) is centred in a corresponding recess of the front plate (65),
- attachment of the submodules (67) on the front plate (65).

10. An aircraft including a cockpit in which an overhead panel according to any one of claims 1 to 8 is installed.
